# FASCICULE DE BREVET EUROPEEN

(11) **EP 3 453 584 B1**
(45) Date de publication et mention de la délivrance du brevet: **11.03.2020**
(21) Numéro de dépôt: 18191278.3
(22) Date de dépôt: 28.08.2018
(51) Int. Cl.: B61C 3/00, B61C 17/04, B61D 27/00

(54) **MOTRICE DE TRAIN À GRANDE VITESSE**
TRIEBWAGEN FÜR HOCHGESCHWINDIGKEITSZUG
POWER UNIT OF HIGH-SPEED TRAIN

(30) Priorité: 30.08.2017 FR 1757996
(43) Date de publication de la demande: 13.03.2019
(73) Titulaire: SpeedInnov, 75008 Paris (FR)
(72) Inventeur: PREISS, Paul, 67110 REICHSHOFFEN (FR); DEBOST, Pierre, 92230 GENEVILLIERS (FR); GRAPPEIN, Etienne, 68 700 Uffholtz (FR); FAVERGER, Marion, 90000 Belfort (FR)
(74) Mandataire: Lavoix

(56) Documents cités:
- EP-A- 0 233 577
- EP-A1- 1 151 904
- EP-A1- 2 078 655
- WO-A1-2012/060139

## Description

La présente invention concerne une motrice de train à grande vitesse, notamment pour le transport de voyageurs, du type comprenant une caisse et au moins un moteur de traction de ladite caisse, ladite caisse comportant une toiture et un plancher, l'au moins un moteur de traction étant disposé sous ledit plancher ; la caisse comportant en outre : un frein rhéostatique disposé en partie supérieure de ladite caisse ; et un premier dispositif de ventilation dudit frein rhéostatique ; la caisse comportant en outre : des équipements électriques de commande de l'au moins un moteur de traction ; et un deuxième dispositif de ventilation desdits équipements électriques.

L'invention s'applique particulièrement au transport de voyageurs. Un train à grande vitesse comprend une ou plusieurs motrices, le plus souvent une à chaque extrémité de rame, et un certain nombre de voitures passagers.

Dans les trains à grande vitesse actuels, la ventilation des équipements électriques des motrices sont assurés par des orifices d'aération ménagés dans des parois latérales desdites motrices. Le déplacement de la rame génère un flux d'air qui refroidit lesdits équipements électriques. Cependant, un tel système de ventilation expose les équipements électriques aux poussières extérieures, à l'humidité, voire à la neige.

Afin de supprimer les ouvertures latérales, il est connu d'aménager les entrées et sorties d'air en toiture, comme par exemple décrit dans le document FR3014396 au nom de la Demanderesse.

Cependant, le dispositif de refroidissement décrit dans ce document nécessite une longueur minimale d'installation. Il est donc incompatible avec la réalisation d'une motrice courte.

Le document EP 0 233 577 A1 décrit une motrice de train à grande vitesse, notamment pour le transport de voyageurs, ladite motrice comprenant une caisse et au moins un moteur de traction de ladite caisse, ladite caisse comportant une toiture et un plancher; l'au moins un moteur de traction étant disposé sous ledit plancher, la caisse comportant en outre: un frein rhéostatique disposé en partie supérieure de ladite caisse; et un premier dispositif de ventilation dudit frein rhéostatique; la caisse comportant en outre: des équipements électriques de commande de l'au moins un moteur de traction; et un deuxième dispositif de ventilation desdits équipements électriques.

Par ailleurs, le refroidissement de certains équipements, tels que le frein rhéostatique, conduit à rejeter de l'air à une température élevée. La présence de cet air chaud peut nuire au refroidissement de certains autres équipements de la motrice.

La présente invention vise à résoudre ces problèmes. A cet effet, l'invention a pour objet une motrice de train à grande vitesse du type précité, dans laquelle : le premier dispositif de ventilation comporte une première gaine d'arrivée d'air, formant un conduit fermé entre une entrée et une sortie ; lesdites entrée et sortie étant situées au niveau, respectivement, d'une première et d'une deuxième bouches d'entrée d'air situées sur la toiture de la caisse ; le deuxième dispositif de ventilation comporte une deuxième gaine d'arrivée d'air, formant un conduit fermé entre une entrée et une sortie ; lesdites entrée et sortie étant situées au niveau, respectivement, d'une troisième bouche d'entrée d'air située sur la toiture de la caisse et d'une quatrième bouche d'entrée d'air située sous le plancher de la caisse ; et chacun des premier et deuxième dispositifs de ventilation comporte un ventilateur disposé entre l'entrée et la sortie, respectivement de la première et de la deuxième gaine.

Suivant d'autres aspects avantageux de l'invention, la motrice comporte l'une ou plusieurs des caractéristiques suivantes, prises isolément ou suivant toutes les combinaisons techniquement possibles :
- la caisse comporte en outre au moins un troisième dispositif de ventilation, ledit troisième dispositif de ventilation comportant une troisième gaine d'arrivée d'air, formant un conduit fermé entre une entrée et une sortie, l'entrée de la troisième gaine étant disposée en toiture de la caisse ;
- le troisième dispositif de ventilation comporte un troisième ventilateur électrique disposé dans la troisième gaine ;
- la caisse comporte en outre au moins un quatrième dispositif de ventilation, ledit quatrième dispositif de ventilation comportant une quatrième gaine d'arrivée d'air, formant un conduit fermé entre une entrée et une sortie, l'entrée de la quatrième gaine étant disposée en toiture de la caisse ;
- le quatrième dispositif de ventilation comporte un quatrième ventilateur électrique disposé dans la quatrième gaine ;
- la caisse comporte un local technique recevant des équipements électriques et/ou électroniques de la motrice ; et la sortie de la troisième gaine est disposée à l'intérieur dudit local technique ;
- la sortie de la troisième gaine est ouverte sous le plancher de la caisse, en vis-à-vis de l'au moins un moteur de traction ;
- la motrice de train à grande vitesse comprend en outre un transformateur électrique relié à l'au moins un moteur de traction ; ledit transformateur étant relié à un radiateur situé sous le plancher de la caisse ; la sortie de la deuxième gaine du deuxième dispositif de ventilation débouchant en vis-à-vis dudit radiateur.

L'invention sera mieux comprise à la lecture de la description qui va suivre, donnée uniquement à titre d'exemple non limitatif et faite en se référant aux dessins sur lesquels :
- la figure 1 est une vue en coupe longitudinale partielle d'une motrice selon un mode de réalisation de l'invention ; et
- les figures 2 et 3 sont des vues en coupe transversale de la motrice de la figure 1.

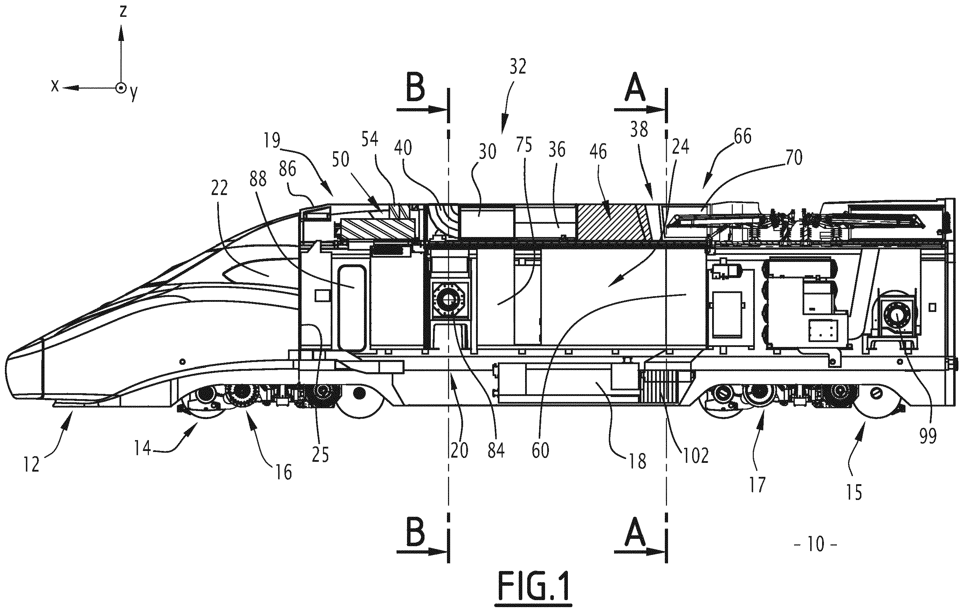

La figure 1 représente une motrice 10 de train à grande vitesse, selon un mode de réalisation de l'invention. La motrice 10 est destinée à être assemblée à des véhicules ferroviaires de type wagons de transports de voyageurs, pour former un train.

La motrice 10 comprend une caisse 12, ainsi que deux bogies 14, 15 et deux moteurs de traction 16, 17, disposés sous ladite caisse 12. Chaque moteur de traction 16, 17 est destiné à mettre en mouvement les roues de l'un des bogies 14, 15. La motrice 10 comprend en outre un transformateur électrique 18, relié aux moteurs de traction 16, 17 et également disposé sous la caisse 12.

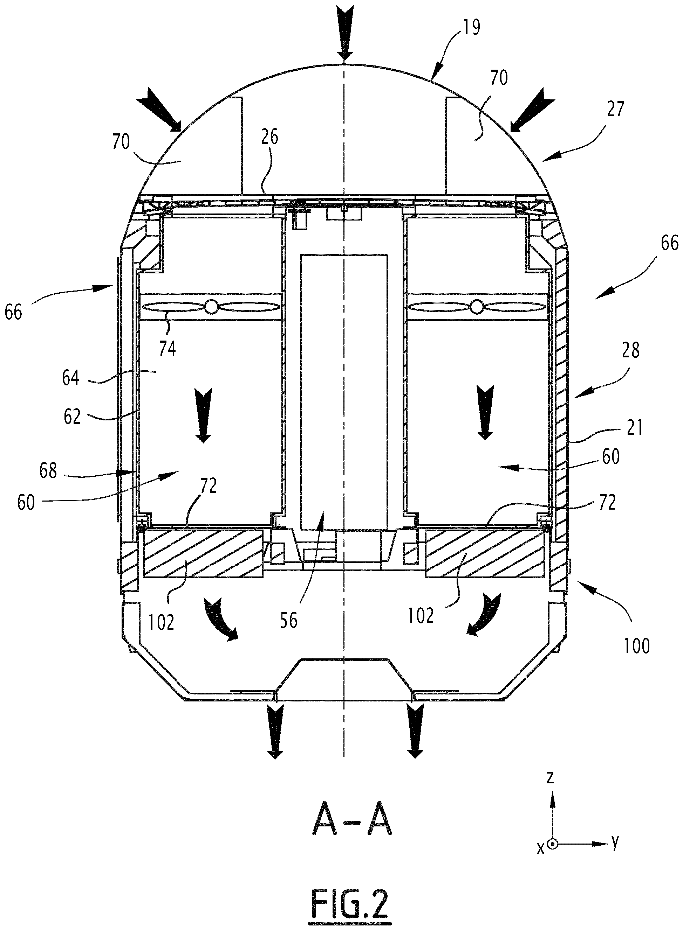

La caisse 12 comporte une toiture 19 et un plancher 20, qui délimitent verticalement ladite caisse. Les bogies 14, 15 et les moteurs de traction 16, 17 sont disposés sous le plancher 20. La caisse 12 comporte en outre des parois latérales 21 (figure 2).

La caisse 12 présente une forme allongée. On considère une base orthonormée (X, Y, Z), la direction Z représentant la verticale. La caisse 12 s'étend principalement selon la direction X, correspondant à une direction de déplacement habituelle de la motrice 10. La caisse 12 comporte une extrémité avant, formée par une cabine de conduite 22.

Un premier bogie 14 et un premier moteur de traction 16 sont situés proches de ladite extrémité avant de la caisse 12. Un deuxième bogie 15 et un deuxième moteur de traction 17 sont situés proches d'une extrémité arrière, opposée, de la caisse 12.

Adjacent à la cabine de conduite 22 selon X, la caisse 12 comporte un compartiment technique 24. Ledit compartiment technique est séparé de la cabine de conduite 22 par une cloison 25. Le compartiment technique 24 est représenté en coupe sur la figure 1.

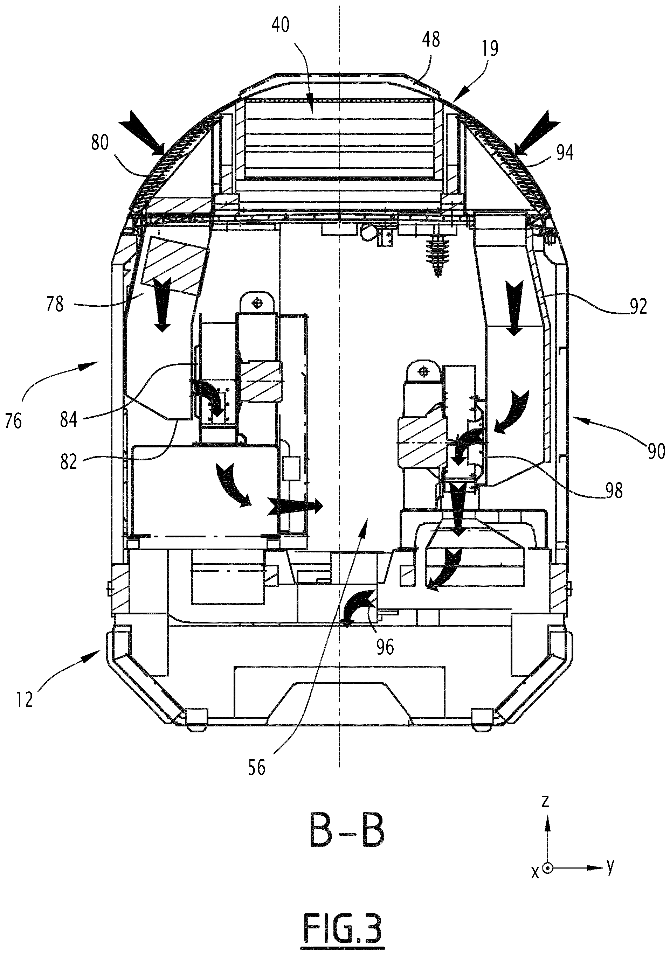

Les figures 2 et 3 montrent des vues en coupe transversale de la caisse 12, au niveau dudit compartiment technique 24, selon des plans de coupe A-A et B-B indiqués sur la figure 1.

Dans un plan (X, Z), le compartiment technique 24 est délimité par la toiture 19, le plancher 20 et les parois latérales 21. Le compartiment technique 24 comporte un plafond 26, qui le divise selon Z entre un étage supérieur 27 et un étage inférieur 28. Le plafond 26 marque notamment une limite selon Z entre les parois latérales 21 et la toiture 19, lesdites parois latérales 21 étant sensiblement planes et verticales et ladite toiture 19 ayant une forme bombée.

L'étage supérieur 27 du compartiment technique 24 comporte un frein rhéostatique 30, sensiblement disposé entre les moteurs de traction 16 et 17 selon la direction X. L'étage supérieur 27 comporte en outre un premier dispositif 32 de ventilation du frein rhéostatique 30.

Le premier dispositif de ventilation 32 comporte une première gaine 36 d'arrivée d'air, sensiblement disposée selon la direction X. Ladite première gaine 36 forme un conduit fermé, à l'exception d'une entrée et d'une sortie situées au niveau de la toiture 19 de la caisse 12. Plus précisément, l'entrée et la sortie de la première gaine 36 sont formées, respectivement, par une première bouche 38 d'entrée d'air et par une deuxième bouche 40 de sortie d'air, incorporées à la toiture 19.

Le premier dispositif de ventilation 32 comporte en outre un premier ventilateur 46 électrique, apte à générer un flux d'air entre l'entrée et la sortie de la première gaine 36. Ledit premier ventilateur 46 et le frein rhéostatique 30 sont disposés à l'intérieur de ladite première gaine 36.

La présence du ventilateur 46 permet notamment de réduire la longueur de la première gaine 36 par rapport au dispositif décrit dans le document FR3014396.

De préférence, le premier dispositif de ventilation 32 comporte des éléments déflecteurs mécaniques, tels que des persiennes 48, au niveau de la première 38 et/ou de la deuxième 40 bouche d'entrée d'air, afin de limiter la pénétration de particules solides dans la première gaine 36.

L'étage supérieur 27 du compartiment technique 24 comporte en outre un système HVAC 50 (Heat Ventilation Air conditioning and Cooling) apte à climatiser la cabine de conduite 22. Le système HVAC 50 est situé à proximité de la cloison 25.

Le système HVAC 50 est isolé fluidiquement du reste du compartiment technique 24 et comporte une troisième bouche d'entrée d'air (non représentée) et une quatrième bouche 54 de sortie d'air, incorporées à la toiture 19. Le système HVAC 50 comporte également un dispositif de soufflerie (non représenté) propre à assurer un mouvement d'air au niveau desdites bouches d'entrée et de sortie 54 d'air. Le système HVAC 50 comporte également des conduits de communication (non représentés) traversant la cloison 25 et configurées pour un échange d'air avec la cabine de conduite 22.

L'étage inférieur 28 du compartiment technique 24 comporte un couloir central 56. Avantageusement, ledit couloir central a une largeur selon Y comprise entre 500 mm et 750 mm, de préférence égale à 750 mm environ. Cette largeur est déterminée pour permettre un passage confortable d'un opérateur, sans limiter sensiblement le volume disponible pour les équipements de la motrice.

L'étage inférieur 28 comporte en outre deux tours de refroidissement 60, situées de part et d'autre du couloir central 56 et s'étendant sensiblement selon Z. Les tours de refroidissement 60 sont sensiblement disposées au-dessus du transformateur électrique 18. Les tours de refroidissement 60 sont visibles en coupe sur la figure 2.

Chaque tour de refroidissement 60 comporte une enveloppe externe 62 qui s'étend du plancher 20 au plafond 26, isolant fluidiquement ladite tour 60 de l'atmosphère du couloir central 56.

A l'intérieur de chaque enveloppe externe 62 est reçu un coffre de traction 64. Ledit coffre de traction 64 comprend des équipements électriques et/ou électroniques de commande des moteurs de traction 16, 17.

L'étage inférieur 28 comporte en outre au moins un deuxième dispositif de ventilation 66, associé à une tour de refroidissement 60. Dans le mode de réalisation des figures 1 à 3, chaque tour de refroidissement 60 est associée à un deuxième dispositif de ventilation 66 distinct. Un seul deuxième dispositif de ventilation 66 sera décrit ci-après.

Le deuxième dispositif de ventilation 66 comporte une deuxième gaine d'arrivée d'air 68. Ladite deuxième gaine 68 forme un conduit fermé, à l'exception d'une entrée 70 et d'une sortie 72.

L'entrée 70 est disposée au niveau de la toiture 19 et préférentiellement formée par une bouche d'entrée d'air, analogue à la première bouche d'entrée d'air 38 du premier dispositif de ventilation 32.

A partir de l'entrée 70, la deuxième gaine 68 s'étend dans l'étage supérieur 27 du compartiment technique 24, traverse le plafond 26 et se poursuit dans l'étage inférieur 28, où elle est matérialisée par l'enveloppe externe 62 de la tour de refroidissement 60. La sortie 72 de la deuxième gaine 68 débouche sous le plancher 20, à proximité du transformateur électrique 18.

Le deuxième dispositif de ventilation 66 comporte en outre un deuxième ventilateur 74 électrique, situé dans la tour de refroidissement 60 et apte à générer un flux d'air entre l'entrée 70 et la sortie 72.

L'étage inférieur 28 comporte en outre une pluralité d'équipements techniques 75, installés de part et d'autre du couloir central 56 à proximité des parois latérales 21. Lesdits équipements techniques sont par exemple des armoires haute tension et/ou des armoires basse tension.

L'étage inférieur 28 comporte en outre un troisième dispositif de ventilation 76, permettant d'insuffler de l'air frais à l'intérieur dudit étage inférieur 28, afin notamment de refroidir les équipements technique 75. Le troisième dispositif de ventilation 76 est visible en coupe sur la figure 3.

Le troisième dispositif de ventilation 76 comporte une troisième gaine d'arrivée d'air 78, formant un conduit fermé à l'exception d'une entrée 80 et d'une sortie 82. L'entrée 80 est disposée au niveau de la toiture 19 et préférentiellement formée par une bouche d'entrée d'air, analogue à la première bouche d'entrée d'air 38 du premier dispositif de ventilation 32. La sortie 82 est disposée dans l'étage inférieur 28.

Le troisième dispositif de ventilation 76 comporte en outre un troisième ventilateur 84 électrique, situé dans l'étage inférieur 28 au niveau de la sortie 82. Le troisième ventilateur 84 est apte à insuffler de l'air extérieur à la caisse 12 dans l'étage inférieur 28.

Le troisième dispositif de ventilation 76 comporte en outre au moins une bouche de sortie d'air 86 (figure 1), située en toiture 19 de la caisse 12 et en communication fluidique avec l'étage inférieur 28 du compartiment technique 24.

L'aspiration de l'air en toiture 19 au lieu d'une aspiration sur les parois latérales 21 permet notamment de réduire le bruit vis-à-vis de l'extérieur.

De préférence, le troisième dispositif de ventilation 76 est situé à l'avant du compartiment technique 24 ; en outre, la caisse 12 comporte un quatrième dispositif de ventilation (non représenté), similaire au troisième dispositif de ventilation 76 et destiné à refroidir l'arrière du compartiment technique 24. Le quatrième dispositif de ventilation est situé de l'autre côté du couloir 56 à l'arrière du compartiment technique 24.

Le compartiment technique 24 comporte au moins une ouverture ménagée dans une paroi latérale 21 et obturée de manière réversible par une porte 88. Ladite porte 88 donne accès de l'extérieur au couloir central 32 de l'étage inférieur 28. De préférence, les parois latérales 21 ne comportent aucune ouverture dégagée de manière permanente. Outre la limitation de la pollution du compartiment technique 24, de telles parois latérales sans ouverture sont plus esthétiques et permettent plus de liberté en matière de design.

La caisse 12 de la motrice 10 comporte au moins un cinquième dispositif de ventilation 90, destiné à refroidir le premier moteur de traction 16. Le cinquième dispositif de ventilation 90 comporte une cinquième gaine 92 d'arrivée d'air, formant un conduit fermé à l'exception d'une entrée 94 et d'une sortie 96. La cinquième gaine 92 est disposée en face de la troisième gaine 78 par rapport au couloir central 56 du compartiment technique 24, comme visible sur la figure 3.

L'entrée 94 est disposée au niveau de la toiture 19 et préférentiellement formée par une bouche d'entrée d'air, analogue à la première bouche d'entrée d'air 38 du premier dispositif de ventilation 32. La sortie 96 est disposée sous le plancher 20.

Le cinquième dispositif de ventilation 90 comporte en outre un cinquième ventilateur 98 électrique, situé dans l'étage inférieur 28 à l'intérieur de la quatrième gaine 92.

La cinquième gaine 92 est isolée fluidiquement du compartiment technique 24. En d'autres termes, il n'y a pas d'échange direct à l'intérieur de la caisse 12 entre l'air circulant dans la cinquième gaine 92 et l'air ambiant du compartiment technique 24. Ainsi, d'éventuelles poussières véhiculées par l'air circulant dans la cinquième gaine 92 sont empêchées de polluer le compartiment technique 24.

De préférence, la caisse 12 comporte en outre un sixième dispositif de ventilation 99, similaire au cinquième dispositif de ventilation 90 et destiné à refroidir le deuxième moteur de traction 17.

Dans tous les dispositifs de ventilation 32, 66, 76, 90, 99 décrits ci-dessus, les bouches d'entrée d'air situées en toiture 19 sont préférentiellement positionnées dans des zones de forte pression pour favoriser l'aspiration. Par ailleurs, chaque dispositif de ventilation dispose de son propre ventilateur 46, 74, 84, 98 et est ainsi indépendant.

La caisse 12 de la motrice 10 comporte en outre un dispositif de refroidissement 100 du transformateur électrique 18. Ledit dispositif de refroidissement 100 comporte deux radiateurs 102, reliés au transformateur électrique 18 par un circuit de fluide caloporteur. Chaque radiateur 102 est disposé sous le plancher 20, en vis-à-vis de la sortie 72 de la deuxième gaine 68 associée à une tour de refroidissement 60. Ainsi, le flux d'air généré par le deuxième ventilateur 74 contribue à refroidir le transformateur électrique 18.

## Revendications

1. Motrice (10) de train à grande vitesse, notamment pour le transport de voyageurs, ladite motrice comprenant une caisse (12) et au moins un moteur de traction (16, 17) de ladite caisse,
ladite caisse comportant une toiture (19) et un plancher (20) ; l'au moins un moteur de traction étant disposé sous ledit plancher,
la caisse comportant en outre : un frein rhéostatique (30) disposé en partie supérieure de ladite caisse ; et un premier dispositif de ventilation (32) dudit frein rhéostatique ;
la caisse comportant en outre : des équipements électriques (64) de commande de l'au moins un moteur de traction ; et un deuxième dispositif de ventilation (66) desdits équipements électriques,
la motrice étant **caractérisée en ce que** :
- le premier dispositif de ventilation comporte une première gaine (36) d'arrivée d'air, formant un conduit fermé entre une entrée et une sortie ; lesdites entrée et sortie étant situées au niveau, respectivement, d'une première (38) et d'une deuxième (40) bouches d'entrée d'air situées sur la toiture (19) de la caisse ;
- le deuxième dispositif de ventilation comporte une deuxième gaine (68) d'arrivée d'air, formant un conduit fermé entre une entrée (70) et une sortie (72) ; lesdites entrée et sortie étant situées au niveau, respectivement, d'une troisième bouche d'entrée d'air située sur la toiture (19) de la caisse et d'une quatrième bouche d'entrée d'air située sous le plancher (20) de la caisse ; et
- chacun des premier et deuxième dispositifs de ventilation comporte un ventilateur (46, 74) disposé entre l'entrée et la sortie, respectivement de la première (36) et de la deuxième (68) gaine.

2. Motrice de train à grande vitesse selon la revendication 1, dans laquelle la caisse comporte en outre au moins un troisième dispositif de ventilation (76, 90, 99), ledit troisième dispositif de ventilation comportant une troisième gaine (78, 92) d'arrivée d'air, formant un conduit fermé entre une entrée et une sortie,
l'entrée (80, 94) de la troisième gaine étant disposée en toiture (19) de la caisse.

3. Motrice de train à grande vitesse selon la revendication 2, dans laquelle le troisième dispositif de ventilation (76, 90, 99) comporte un troisième ventilateur électrique (84, 98) disposé dans la troisième gaine (78, 92).

4. Motrice de train à grande vitesse selon la revendication 2 ou la revendication 3, dans laquelle la caisse comporte en outre au moins un quatrième dispositif de ventilation (76, 90, 99), ledit quatrième dispositif de ventilation comportant une quatrième gaine (78, 92) d'arrivée d'air, formant un conduit fermé entre une entrée et une sortie,
l'entrée (80, 94) de la quatrième gaine étant disposée en toiture (19) de la caisse.

5. Motrice de train à grande vitesse selon la revendication 4, dans laquelle le quatrième dispositif de ventilation (76, 90, 99) comporte un quatrième ventilateur électrique (84, 98) disposé dans la quatrième gaine (78, 92).

6. Motrice de train à grande vitesse selon l'une des revendications 2 à 5, dans laquelle :
- la caisse (12) comporte un local technique (28) recevant des équipements électriques et/ou électroniques de la motrice ; et
- la sortie (82) de la troisième gaine est disposée à l'intérieur dudit local technique.

7. Motrice de train à grande vitesse selon l'une des revendications 2 à 5, dans laquelle la sortie (96) de la troisième gaine (92) est ouverte sous le plancher (20) de la caisse, en vis-à-vis de l'au moins un moteur de traction (16).

8. Motrice de train à grande vitesse selon l'une des revendications précédentes, comprenant en outre un transformateur électrique (18) relié à l'au moins un moteur de traction (16, 17) ;
ledit transformateur étant relié à un radiateur (102) situé sous le plancher (20) de la caisse ;
la sortie (72) de la deuxième gaine (68) du deuxième dispositif de ventilation (66) débouchant en vis-à-vis dudit radiateur.

## Patentansprüche

1. Triebwagen (10) für einen Hochgeschwindigkeitszug, insbesondere für den Transport von Reisenden, wobei der Triebwagen einen Kasten (12) und mindestens einen Antriebsmotor (16, 17) für den Kasten umfasst, wobei
der Kasten ein Dach (19) und einen Boden (20) aufweist; der mindestens eine Antriebsmotor unter dem Boden angeordnet ist,
der Kasten außerdem aufweist: eine Widerstandsbremse (30), die teilweise über dem Kasten angeordnet ist; und eine erste Lüftungsvorrichtung (32) der Widerstandsbremse;
der Kasten außerdem aufweist: elektrische Vorrichtungen (64) zur Steuerung des mindestens einen Antriebsmotor; und eine zweite Lüftungsvorrichtung (66) der elektrischen Vorrichtungen,
der Triebwagen **dadurch gekennzeichnet ist, dass**:
- die erste Lüftungsvorrichtung einen ersten Zuluftmantel (36) aufweist, der einen geschlossenen Kanal zwischen einem Eintritt und einem Austritt bildet; wobei der Eintritt und Austritt jeweils an einer ersten (38) und einer zweiten (40) Mündung für den Eintritt von Luft liegen, die auf dem Dach (19) des Kastens angeordnet sind;
- die zweite Lüftungsvorrichtung einen zweiten Zuluftmantel (68) aufweist, der einen geschlossenen Kanal zwischen einem Eintritt (70) und einem Austritt (72) bildet, wobei der Eintritt und Austritt jeweils an einer dritten Mündung für den Eintritt von Luft, die auf dem Dach (19) des Kastens angeordnet ist, und einer vierten Mündung für den Eintritt von Luft, die unter dem Boden (20) des Kastens angeordnet ist, liegen; und
- jede von der ersten und zweiten Lüftungsvorrichtung einen Ventilator (46, 74) aufweist, der zwischen dem Eintritt und dem Austritt jeweils des ersten (36) und des zweiten (68) Mantels angeordnet ist.

2. Triebwagen für einen Hochgeschwindigkeitszug nach Anspruch 1, bei dem der Kasten außerdem mindestens eine dritte Lüftungsvorrichtung (76, 90, 99) aufweist, wobei die dritte Lüftungsvorrichtung einen dritten Zuluftmantel (78, 92) aufweist, der einen geschlossenen Kanal zwischen einem Eintritt und einem Austritt bildet,
wobei der Eintritt (80, 94) des dritten Mantels in dem Dach (19) des Kastens angeordnet ist.

3. Triebwagen für einen Hochgeschwindigkeitszug nach Anspruch 2, bei dem die dritte Lüftungsvorrichtung (76, 90, 99) einen dritten elektrischen Ventilator (84, 98) aufweist, der in dem dritten Mantel (78, 92) angeordnet ist.

4. Triebwagen für einen Hochgeschwindigkeitszug nach Anspruch 2 oder Anspruch 3, bei dem der Kasten außerdem eine vierte Lüftungsvorrichtung (76, 90, 99) aufweist, wobei die vierte Lüftungsvorrichtung einen vierten Zuluftmantel (78, 92) aufweist, der einen geschlossenen Kanal zwischen einem Eintritt und einem Austritt bildet,
wobei der Eintritt (80, 94) des vierten Mantels in dem Dach (19) des Kastens angeordnet ist.

5. Triebwagen für einen Hochgeschwindigkeitszug nach Anspruch 4, bei dem die vierte Lüftungsvorrichtung (76, 90, 99) einen vierten elektrischen Ventilator (84, 98) aufweist, der in dem vierten Mantel (78, 92) angeordnet ist.

6. Triebwagen für einen Hochgeschwindigkeitszug nach einem der Ansprüche 2 bis 5, bei dem:
- der Kasten (12) einen Technikraum (28) aufweist, der die elektrischen und/oder elektronischen Vorrichtungen des Triebwagens aufnimmt; und
- der Austritt (82) des dritten Mantels im Inneren des Technikraums angeordnet ist.

7. Triebwagen für einen Hochgeschwindigkeitszug nach einem der Ansprüche 2 bis 5, bei dem der Austritt (96) des dritten Mantels (92) unter dem Boden (20) des Kastens gegenüber dem mindestens einen Antriebsmotor (16) offen ist.

8. Triebwagen für einen Hochgeschwindigkeitszug nach einem der vorhergehenden Ansprüche, außerdem einen elektrischen Transformator (18) umfassend, der mit dem mindestens einen Antriebsmotor (16, 17) verbunden ist; wobei
der Transformator an einen Kühler (102) angeschlossen ist, der unter dem Boden (20) des Kastens angeordnet ist;
der Austritt (72) des zweiten Mantels (68) der zweiten Lüftungsvorrichtung (66) dem Kühler gegenüber mündet.

## Claims

1. A power car (10) for a high-speed train, in particular for transporting passengers, said power car including a body (12) and at least one traction motor (16, 17) of said body,
said body comprising a roof (19) and a floor (20); the at least one traction motor being arranged under said floor,
the body further comprising: a rheostatic brake (30) arranged in an upper part of said body; and a first ventilation device (32) of said rheostatic brake;
the body further comprising: electrical equipments (64) for controlling the at least one traction motor; and a second ventilation device (66) of said electrical equipments,
the power car being **characterized in that**:
- the first ventilation device comprises a first air intake sheath (36), forming a closed pipe between an inlet and an outlet; said inlet and outlet being located respectively at the level of a first (38) and second (40) air inlet mouth located on the roof (19) of the body;
- the second ventilation device comprises a second air intake sheath (68), forming a closed pipe between an inlet (70) and an outlet (72); said inlet and outlet being located respectively at the level of a third air inlet mouth located on the roof (19) of the body and a fourth air inlet mouth located under the floor (20) of the body; and
- each of the first and second ventilation devices comprises a fan (46, 74) arranged between the inlet and the outlet, respectively of the first (36) and second (68) sheath.

2. The power car for a high-speed train according to claim 1, wherein the body further comprises at least a third ventilation device (76, 90, 99), said third ventilation device comprising a third air intake sheath (78, 92), forming a closed pipe between an inlet and an outlet, the inlet (80, 94) of the third sheath being arranged on the roof (19) of the body.

3. The power car for a high-speed train according to claim 2, wherein the third ventilation device (76, 90, 99) comprises a third electric fan (84, 98) arranged in the third sheath (78, 92).

4. The power car for a high-speed train according to claim 2 or claim 3, wherein the body further comprises at least a fourth ventilation device (76, 90, 99), said fourth ventilation device comprising a fourth air intake sheath (78, 92), forming a closed pipe between an inlet and an outlet,
the inlet (80, 94) of the fourth sheath being arranged on the roof (19) of the body.

5. The power car for a high-speed train according to claim 4, wherein the fourth ventilation device (76, 90, 99) comprises a fourth electric fan (84, 98) arranged in the fourth sheath (78, 92).

6. The power car for a high-speed train according to one of claims 2 to 5, wherein:
- the body (12) comprises an equipment room (28) receiving electrical and/or electronic equipments of the power car; and
- the outlet (82) of the third sheath is arranged inside said equipment room.

7. The power car for a high-speed train according to one of claims 2 to 5, wherein the outlet (96) of the third sheath (92) is open under the floor (20) of the body, opposite the at least one traction motor (16).

8. The power car for a high-speed train according to one of the preceding claims, further including an electrical transformer (18) connected to the at least one traction motor (16, 17);
said transformer being connected to a radiator (102) located under the floor (20) of the body;
the outlet (72) of the second sheath (68) of the second ventilation device (66) opening opposite said radiator.
